Europäisches Patentamt

European Patent Office

Office européen des brevets

(19)

(11) Numéro de publication: **0 279 738**
**A1**

## (12) DEMANDE DE BREVET EUROPEEN

(21) Numéro de dépôt: 88400318.7

(22) Date de dépôt: 12.02.88

(51) Int. Cl.⁴: **G 06 F 11/26**
**G 01 R 31/28**

(30) Priorité: 17.02.87 FR 8702003

(43) Date de publication de la demande:
24.08.88 Bulletin 88/34

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Du Chêne, Arnaud**
**THOMSON-CSF SCPI 19, avenue de Messine**
**F-75008 Paris (FR)**

**Dias, Bernard**
**THOMSON-CSF SCPI 19, avenue de Messine**
**F-75008 Paris (FR)**

(74) Mandataire: **Benoit, Monique et al**
**THOMSON-CSF SCPI 19, avenue de Messine**
**F-75008 Paris (FR)**

(54) Dispositif de test de circuit électrique et circuit comportant ledit dispositif.

(57) L'invention a principalement pour objet un dispositif de test de circuit électrique et un circuit comportant ledit dispositif.

L'invention concerne principalement un dispositif de test des circuits électriques par génération de vecteurs de tests et compression du signal en sortie du dispositif à tester. Le dispositif selon la présente invention utilise le même registre à décalage (2) dont certaines cellules sont bouclées sur l'entrée par l'intermédiaire d'une logique OU-exclusif (3) pour effectuer la génération des vecteurs de test et l'analyse des signatures. Ainsi il est possible d'effectuer le test de circuits électriques eux-mêmes ainsi que les bus d'entrée/sortie.

L'invention s'applique notamment aux tests des calculateurs, des microprocesseurs, des mémoires, des calculateurs de transformée de Fourier rapide, des additionneurs, des multiplieurs, des logiques combinatoires, ainsi que des logiques combinatoires comportant des dispositifs de mémorisation interne.

FIG_5

EP 0 279 738 A1

## Description

## DISPOSITIF DE TEST DE CIRCUIT ELECTRIQUE ET CIRCUIT COMPORTANT LEDIT DISPOSITIF

La présente invention a principalement pour objet un dispositif de test de circuit électrique et un circuit comportant ledit dispositif.

La présente invention se rapporte principalement aux tests de bon fonctionnement de circuits électriques comme par exemple des circuits numériques et/ou logiques. Elle permet de détecter le mauvais fonctionnement d'un circuit intégré, circuit imprimé ou de tout autre dispositif électronique. Une fois la panne détectée, il est possible, de prendre les mesures permettant de minimiser les conséquences de cette panne. Par exemple, on remplace le circuit électrique défaillant, ou l'on ne tient pas compte du résultat fourni par ledit circuit.

L'augmentation de complexité des circuits électroniques rend de plus en plus difficile un test exhaustif de ces circuits, détectant à coup sûr toute panne. Il est connu des méthodes permettant un test ayant de très grandes chances de détecter une panne dans un circuit. Notamment, il est connu d'injecter dans le circuit numérique et/ou logique des suites de vecteurs pseudo-aléatoires longues. Les suites pseudo-aléatoires longues sont obtenues en rebouclant certaines cellules d'un registre à décalage à travers une porte OU-exclusif. En utilisant des polynomes générateurs de degré N il est possible d'obtenir des suites ayant une longueur $2^N - 1$.

A la sortie du dispositif à tester il suffit de vérifier la conformité des résultats obtenus avec ceux qui devraient être fournis par une carte en bon état de fonctionnement. Par exemple on compare le résultat obtenu avec ceux fournis par une carte que l'on sait fonctionner parfaitement, ou alors avec des résultats que l'on a obtenu par simulation.

Une méthode plus perfectionnée consiste à utiliser l'analyse des signatures. Cette méthode est connue sous le nom de méthode BILBO. A la sortie du dispositif à tester on connecte un autre registre à décalage dont certaines cellules sont rebouclées à travers une porte OU-exclusif. Ce second registre à décalage muni de sa porte logique OU-exclusif permet de comprimer les informations obtenues. A la fin du test il suffit de comparer le contenu du registre à décalage avec celui qui devrait être obtenu, pour un dispositif en parfait état de fonctionnement, pour détecter, avec une très grande efficacité, si le dispositif testé est en panne ou non.

Le dispositif de type connu présente l'inconvénient de ne pas effectuer les tests de bus d'entrée/sortie du dispositif.

Le dispositif objet de la présente invention utilise un registre à décalage unique bouclé à travers, une porte logique OU-exclusif pour effectuer la génération des vecteurs de test ainsi que la compression d'information. Ce dispositif est connecté au bus d'entrée/sortie du système à tester. Ainsi il permet de détecter des collages à 0 ou des collages à 1 sur ce bus. Par contre il ne permet pas de détecter des coupures de bus. Le dispositif selon la présente invention comporte un multiplexeur permettant d'envoyer vers le registre à décalage les informations présentes à la sortie du dispositif à tester.

De plus, l'utilisation d'un registre à décalage unique pour la génération de vecteurs de test et pour la compression des réponses fournies par le dispositif à tester permet de réduire la quantité de matériel nécessaire à la réalisation du test. Cette réduction sera particulièrement importante par rapport au matériel total dans le cas de dispositif de test inclus dans des circuits intégrés.

L'utilisation d'un même registre à décalage pour la génération des vecteurs de tests et pour la compression des informations entraîne la modification du contenu du registre à décalage entre la génération de deux vecteurs des tests successifs, par rapport à leur contenu dans le fonctionnement du générateur de tests de type connu. A priori on pourrait s'attendre à une très importante diminution de l'efficacité des tests, c'est-à-dire du nombre de pannes détectées par rapport au nombre de pannes réelles. L'expérimentation a permis de prouver qu'il était possible d'obtenir une effica cité supérieure à 99%, par exemple 99,6%.

Dans une variante de réalisation du dispositif selon la présente invention le dispositif de test est inclus dans le dispositif à tester, par exemple, un circuit intégré ou un circuit imprimé.

Dans une deuxième variante de réalisation du dispositif selon la présente invention il est commun à un ensemble d'équipement. Il est possible de réaliser le test d'un équipement particulier en le branchant sur un bus entrée/sortie commun.

Dans une troisième variante de réalisation le dispositif de test selon la présente invention est autonome. Il est possible de le brancher sur un quelconque équipement pour en effectuer le test.

L'invention a principalement pour objet un dispositif de test pour circuit électrique et notamment pour circuits numériques et/ou logiques comportant un registre à décalage dont au moins une cellule est reliée aux entrées d'une porte logique OU-exclusif, la sortie de ladite porte logique OU-exclusif étant connectée sur l'entrée dudit registre à décalage, caractérisé par le fait que le registre à décalage est susceptible d'être connecté à l'entrée du dispositif à tester pour générer des vecteurs de test et à la sortie du dispositif à tester pour comprimer les informations disponibles en sortie de façon à permettre d'effectuer l'analyse de signature dudit dispositif à tester.

L'invention sera mieux comprise au moyen de la description ci-après et des figures données comme des exemples non limitatifs parmi lesquels :
- la figure 1 est un schéma d'un générateur de vecteur de test de type connu ;
- la figure 2 est un schéma d'un dispositif de compression d'information de type connu ;

- la figure 3 est un schéma d'un dispositif de test de type BILBO ;
- la figure 4 est un schéma d'un premier exemple de réalisation du dispositif selon la présente invention ;
- la figure 5 est un schéma d'un second exemple de réalisation du dispositif selon la présente invention.

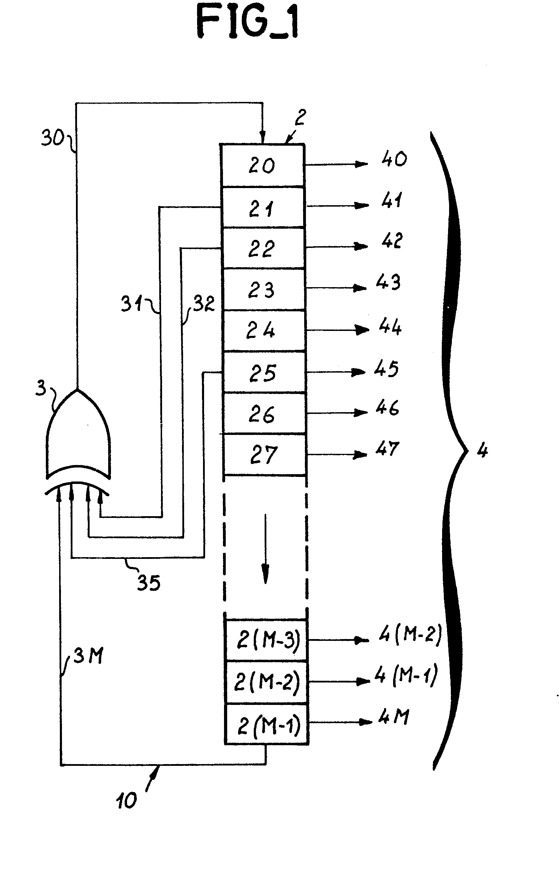

Sur les figures 1 à 5 on a utilisé les mêmes références pour désiger les mêmes éléments.

Sur la figure 1, on peut voir le principe d'un générateur 10 de signaux pseudo-aléatoires. Ledit générateur comporte un registre à décalage 2 comportant M cellules référencées 20 à 2(M-1), et une porte logique OU-exclusif 3. Le registre à décalage 2 décale, à chaque impulsion d'horloge (non illustrée) l'information présente dans une cellule dans le sens des références croissantes. Ainsi après M cycles d'horloge une information présentée à l'entrée de la cellule 20 est présente à la sortie de la cellule 2(M-1). La cellule 2(M-1) est reliée à une des entrées de la porte logique OU-exclusif 3 par une ligne 3M. La sortie de la porte logique OU-exclusif 3 est reliée par une ligne 30 à la cellule 20. Certaines cellules du registre à décalage 2 sont reliées à des entrées de la porte logique OU-exclusif 3. Dans l'exemple, du registre illustré sur la figure 1 la cellule 21 est reliée par la ligne 31 à une entrée de la porte logique OU-exclusif 3, la cellule 22 est reliée par la ligne 32 à une entrée de la porte logique OU-exclusif 3 ainsi que la cellule 25 est reliée par la ligne 35 à une entrée de la porte logique OU-exclusif 3.

Le tableau I donne les puissances non triviales de polynomes générateurs permettant pour un registre à décalage comportant M cellules d'obtenir $2^M-1$ mots de M bits différents.

## TABLEAU I

### Polynomes générateurs

| Degrés | Puissances non triviales |
|---|---|
| 16 | 9, 7, 4 |
| 20 | 3 |
| 21 | 2 |
| 22 | 1 |
| 23 | 5 |
| 24 | 24, 7, 2, 1 |
| 25 | 3 |
| 26 | 6, 2, 1 |
| 27 | 5, 2, 1 |
| 28 | 3 |
| 29 | 2 |
| 30 | 23, 2, 1 |
| 31 | 3 |
| 32 | 22, 2, 1 |
| 33 | 13 |

Ainsi si par exemple nous voulons utiliser le polynome générateur de degré 27 :

$P_{27}(X) = X^{27} + X^5 + X^2 + X + 1$

nous allons utiliser un registre à décalage 1 comportant 27 cellules.

Dans ce cas en plus de la première cellule 2(M-1) toujours bouclée sur une entrée de la porte logique OU-exclusif 3 nous reboucierons la seconde, la troisième et la sixième cellules référencées respectivement 21, 22 et 25 sur la figure 1.

Les mots de M bits sont disponibles sur les sorties 4 du registre à décalage 2. Dans l'exemple illustré sur la figure 1 les sorties du registre à déclage 2 sont référencées 40 à 4(M-1).

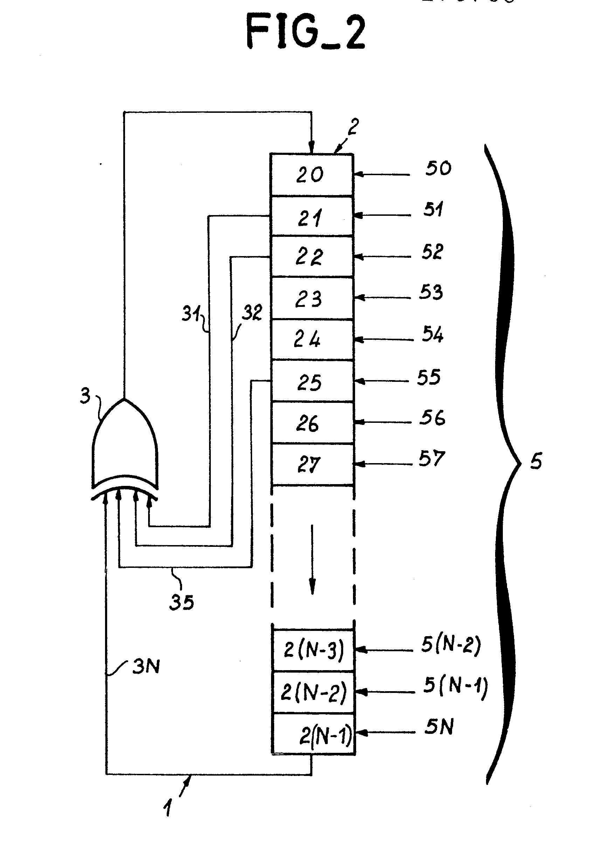

Sur la figure 2, on peut voir le principe d'un dispositif de compression d'information utilisé pour l'analyse des signaux pour test de circuit électrique.

Le dispositif illustré sur la figure 2 comporte un registre à décalage de N cellules référencé 20 à 2(N-1) et une porte logique OU-exclusif 3. Le registre à décalage 2 décale à chaque impulsion d'horloge (non illustrée)

**0 279 738**

l'information présente dans une des cellules dans un sens de référence croissant et modifiée par une fonction OU-exclusif par le signal 5 correspondant. La cellule 2(N-1) est reliée à une des entrées de la porte logique OU-exclusif 3 par une ligne 3N. La sortie de la porte logique OU-exclusif 3 est reliée par une ligne 30 à la cellule 20. Certaines cellules du registre à décalage 2 sont reliées à des entrées de la porte logique OU-exclusif 3. Dans l'exemple illustré sur la figure 2, la cellule 21 est reliée par la ligne 31 à une entrée de la porte OU-exclusif 3, la cellule 22 est reliée par la ligne 32 à une entrée de la porte logique OU-exclusif 3, ainsi que la cellule 25 est reliée par la ligne 35 à l'entrée de la porte logique OU-exclusif 3.

Les données à compresser sont rentrées dans un registre à décalage 2 par l'intermédiaire des entrées 5. Sur la figure 2 les entrées 5 correspondant aux cellules 20 à 2(N-1) sont référencées 50 à 5(N-1). Le résultat de la compression est lu soit par l'intermédiaire des entrées 5, en parallèle, soit en série par l'intermédiaire de la ligne 3N reliée à la dernière cellule du registre à décalage 2, 2(N-1).

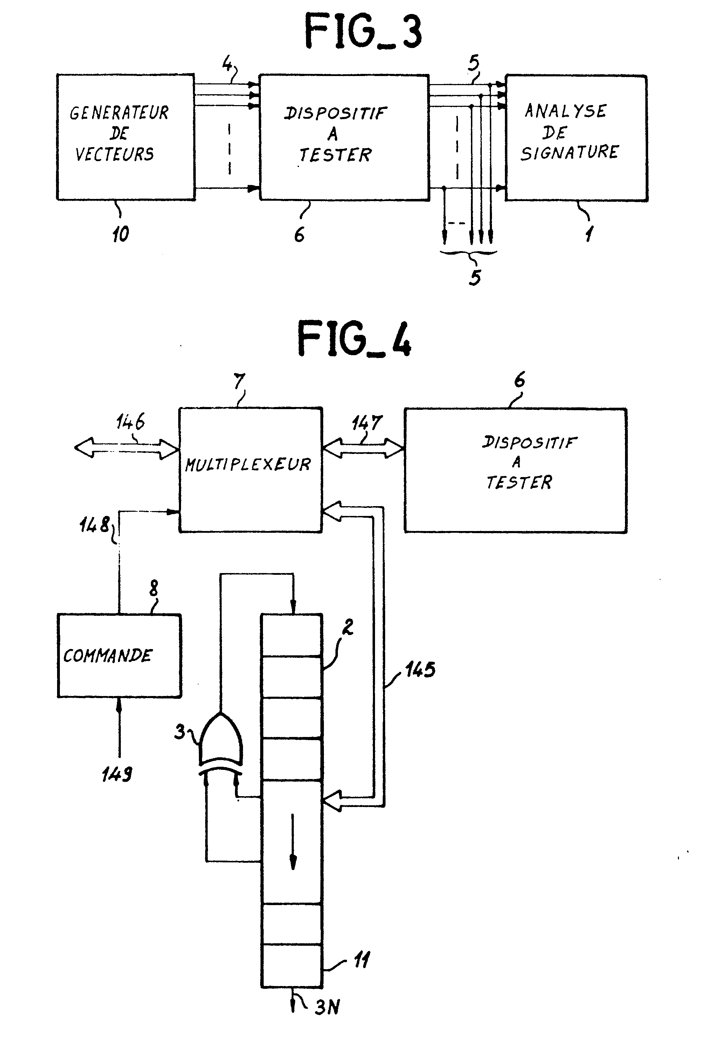

Sur la figure 3, on peut voir un exemple de dispositif de test de type BILBO. Les entrées du dispositif à tester, par exemple un circuit intégré sont reliés aux sorties 4 du générateur de vecteur de test 10, par exemple analogue au générateur de vecteur de test illustré sur la figure 1.

Les sorties du dispositif à tester sont reliées aux entrées 5 du dispositif d'analyse de signature. Le dispositif d'analyse de signature 1 est par exemple analogue au dispositif illustré sur la figure 2. Dans l'exemple illustré sur la figure 3 les sorties 5 sont susceptibles d'être lues à l'extérieur permettant la lecture en fin de test des valeurs contenues par le registre à décalage 2.

Sur la figure 4, on peut voir un exemple de réalisation du dispositif selon l'invention. Dans l'exemple de la figure 4 le dispositif à tester 6 est normalement relié à un bus d'entrée/sortie externe 146. Pour pouvoir à tout moment réaliser les tests du dispositif à tester 6 le bus 146 est relié à un multiplexeur 7. Le multiplexeur 7 est relié au dispositif à tester 6 par l'intermédiaire d'un bus 147, et à un dispositif de test 11 par un bus 145. Le dispositif de test 11 comporte un registre à décalage 2 dont certaines cellules sont rebouclées par une porte OU-exclusif 3 à son entrée. Les cellules du registre à décalage 2 sont susceptibles d'être lues et écrites en parallèle par l'intermédiaire du bus 145.

Le multiplexeur 7 permet soit de relier le bus 146 au bus 147, soit de relier le bus 145 au bus 147. Le multiplexeur 7 comporte par exemple des dispositifs trois états (three state en terminologie anglo-saxonne).

Au premier cycle d'horloge le registre à décalage 2 est initialisé, par exemple toutes les cellules du registre à décalage 2 comportent la valeur 1. A un cycle horloge sur deux, par exemple pendant les cycles d'horloge pairs le dispositif de test 11 transmet par l'intermédiaire du bus 145 du multiplexeur 7 et du bus 147 aux entrées du dispositif à tester 6 des vecteurs de test. Pendant les cycles d'horloge complémentaires c'est-à-dire dans notre exemple pendant le cycle d'horloge impair le registre à décalage 2 du dispositif de test 11 reçoit par l'intermédiaire du bus 147, du multiplexeur 7 et du bus 145 les valeurs des sorties générées en réponse aux vecteurs de tests par le dispositif à tester 6.

Ainsi, les vecteurs de tests générés par le dispositif 11 sont les réponses modifiées aux vecteurs de tests précédents du dispositif 6. Il à noter que le dispositif 11 ne va plus générer $2^N$ vecteurs différents de N bits pour le test. Néanmoins dans la plupart des cas il a été vérifié expérimentalement que l'on obtient un test quasi exhaustif. Il a été notamment vérifié pour les polynomes générateurs $F(X) = X^{33} + X^{13} + 1$ et pour le polynome $X^{47} + 1$. Ce polynome présente en plus l'avantage de nécessiter peu de connexion au niveau de la porte logique OU-exclusif 3.

Le résultat du test est lu soit par un bus série 3N connecté à la dernière sortie du registre à décalage 2 soit, avantageusement par l'intermédiaire du bus 145 du multiplexeur 7 et du bus 146.

Le dispositif de commande 8 permet de commander le multiplexeur 7.

En dehors des périodes de test le bus 146 est relié par le multiplexeur 7 au bus 147. Le dispositif de test 11 est parfaitement transparent à l'utilisateur. Dans la période de test le dispositif de commande 8 effectue les commutations nécessaires. Par exemple, les dispositifs de commande 8 comportent des compteurs permettant de mesurer le nombre de cycles effectués. Avantageusement le dispositif de commande 8 comporte un circuit logique permettant d'automatiser le test. Le test effectué soit périodiquement, soit sur commande 149 du dispositif de commande 8.

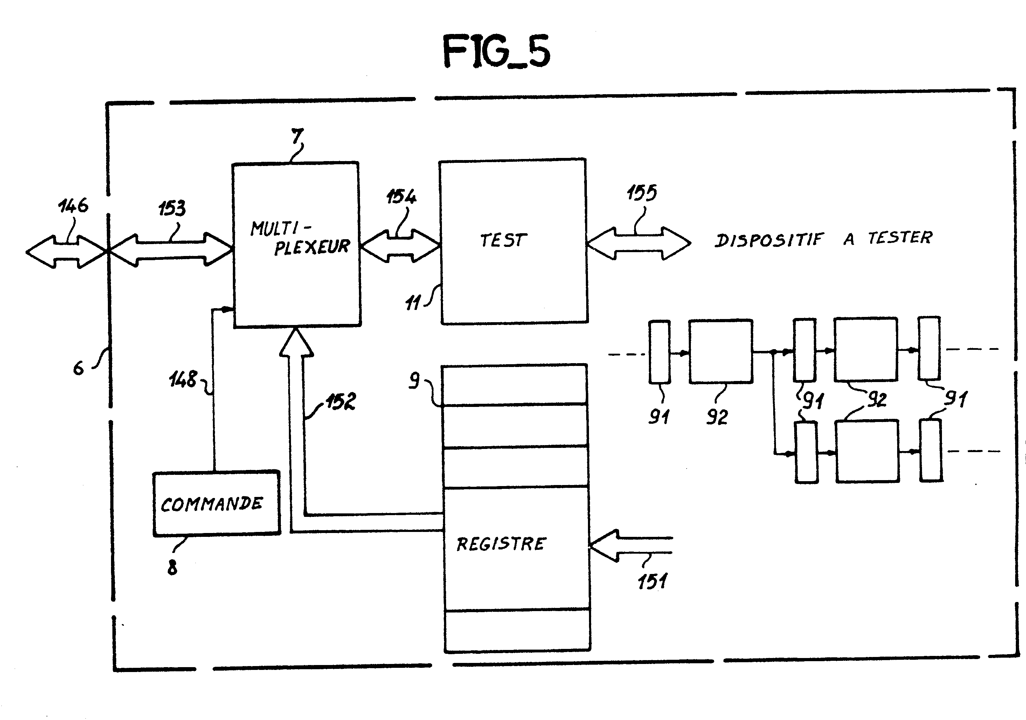

Sur la figure 5, on peut voir un second exemple de réalisation du dispositif selon l'invention. Dans l'exemple illustré sur la figure 5, le dispositif de test est intégré au dispositif à tester. Par exemple le dispositif à tester 6 est un circuit intégré réalisant la transformée de Fourier rapide (FFT en terminologie anglo-saxonne). Le bus externe d'entrée/sortie 146 est relié au bus interne d'entrée/sortie 153. Le bus interne d'entrée/sortie 153 est relié au multiplexeur 7. Le multiplexeur 7 est relié d'une part au bus 154 et d'autre part au bus 152. Le bus 154 est un bus bidirectionnel reliant le multiplexeur 7 au dispositif de test 11. Le dispositif de test 11 est relié à un bus interne 155.

Le bus 152 est par exemple le bus de sortie interne du dispositif à tester 6. Avantageusement, le bus de sortie interne 151 est relié à un registre 9, lui-même relié au bus 152.

Un dispositif de commande 8 est relié par un bus 148 au multiplexeur 7.

Le multiplexeur 7 permet soit de relier par l'intermédiaire de bus 153 et 154 le bus 146 au bus 155, soit de relier, par l'intermédiaire de bus 152 et 154 le bus 151 au dispositif de test 11. Le premier cas correspond au fonctionnement normal du dispositif à tester 6. Dans ce cas, il est avantageux d'utiliser le registre à décalage 2 du dispositif de test 11 comme registre tampon d'entrée/sortie du dispositif à tester 6.

Le second correspond au test du dispositif à tester 6.

Dans une variante particulièrement avantageuse de l'invention le multiplexeur 7 permet d'aiguiller les signaux du bus 152 vers le bus 154, sans pour autant isoler le bus 154 du bus 153 relié au bus 146. Ainsi, tout collage à 0 ou à 1 donne des bits du bus 146 ou du bus 153 modifiant le contenu du registre 2 du dispositif du test 11. Ce collage à 0 ou à 1 va donc être détecté comme une faute de fonctionnement du dispositif à tester 6.

L'invention s'applique principalement au test de circuit électrique, notamment des circuits numériques et/ou logiques.

L'invention s'applique notamment aux tests des circuits intégrés, des circuits imprimés, et de tout dispositif utilisant le traitement du signal.

L'invention s'applique particulièrement aux tests des calculateurs, des microprocesseurs, des mémoires, des calculateurs de transformée de Fourier rapide, des additionneurs, des multiplieurs, des logiques combinatoires, ainsi que des logiques combinatoires comportant des dispositifs de mémorisation interne.

## Revendications

1. Dispositif de test pour circuit électrique et notamment pour circuits numériques et/ou logiques comportant un registre à décalage dont au moins une cellule est reliée aux entrées d'une porte logique OU-exclusif, la sortie de ladite porte logique OU-exclusif étant connectée sur l'entrée dudit registre à décalage, caractérisé par le fait que le registre (2) à décalage est susceptible d'être connecté à l'entrée du dispositif à tester (6) pour générer des vecteurs de test et à la sortie du dispositif à tester (6) pour comprimer les informations disponibles en sortie de façon à permettre d'effectuer l'analyse de signature dudit dispositif à tester.

2. Dispositif de test selon la revendication 1, caractérisé par le fait qu'il comporte un multiplexeur (7) susceptible de relier le bus d'entrée/sortie externe (146) et/ou la sortie du dispositif à tester (6) à l'entrée du dispositif à tester.

3. Dispositif de test selon la revendication 1 ou 2, caractérisé par le fait qu'il comporte un dispositif (8) de commande du multiplexeur (7).

4. Circuit électronique, caractérisé par le fait qu'il comprend un dispositif de test selon l'une quelconque des revendications précédentes.

5. Circuit selon la revendication 4, caractérisé par le fait que ledit circuit est un circuit imprimé.

6. Circuit selon la revendication 4, caractérisé par le fait que ledit circuit est un circuit intégré.

7. Circuit selon la revendication 4, 5 ou 6, caractérisé par le fait que ledit circuit comporte une partie combinatoire.

8. Circuit selon la revendication 4, 5, 6 ou 7, caractérisé par le fait qu'il comporte des moyens de mémorisation.

9. Circuit selon la revendication 4, 5, 6, 7 ou 8, caractérisé par le fait que durant le test les bus d'entrée/sortie (146, 153) et la sortie du circuit à tester (152) sont simultanément connectés au registre à décalage (2).

10. Circuit selon la revendication 4, 5, 6, 7, 8 ou 9, caractérisé par le fait que les cellules du registre à décalage (2) relié aux entrées de la porte logique OU-exclusif (3) correspondent aux puissances non triviales d'un polynome générateur.

0279738

# FIG_1

FIG_2

0279738

0279738

# FIG_3

GENERATEUR DE VECTEURS — 10

DISPOSITIF A TESTER — 6

ANALYSE DE SIGNATURE — 1

# FIG_4

MULTIPLEXEUR — 7

DISPOSITIF A TESTER — 6

COMMANDE — 8

FIG_5

Office européen
des brevets

# RAPPORT DE RECHERCHE EUROPEENNE

Numero de la demande

EP 88 40 0318

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | IBM TECHNICAL DISCLOSURE BULLETIN, vol. 25, no. 10, mars 1983, pages 4958-4960, New York, US; P.S. BOTTORFF et al.: "Self-testing scheme using shift register latches" * En entier * | 1 | G 06 F 11/26 G 01 R 31/28 |
| A | Idem --- | 7,8 | |
| X | US-A-4 571 724 (BELMONDO et al.) * Colonne 4, lignes 11-64; figure 1 * | 1 | |
| A | --- | 2-4,7 | |
| A | EP-A-0 037 965 (SIEMENS) * Page 1, lignes 8-14 * --- | 5,6 | |
| A | IBM TECHNICAL DISCLOSURE BULLETIN, vol. 26, no. 3B, août 1983, pages 1604-1606, New York, US; D.A. CALVIN: "Design for self-test SRL implementation" * En entier * --- | | |
| A | IBM TECHNICAL DISCLOSURE BULLETIN, vol. 26, no. 10B, mars 1984, pages 5566-5570, New York, US; A. BLUM: "Self-testing mechanism" * En entier * ----- | | |

DOMAINES TECHNIQUES RECHERCHES (Int. Cl.4)

G 06 F 11/26
G 01 R 31/28

Le présent rapport a été établi pour toutes les revendications

| Lieu de la recherche | Date d'achèvement de la recherche | Examinateur |
|---|---|---|
| LA HAYE | 11-04-1988 | ADRIAENSSENS M.T.K.P. |